# DEMANDE DE BREVET EUROPEEN

(11) **EP 2 263 972 A1**
(43) Date de publication de la demande: **22.12.2010**
(21) Numéro de dépôt: 09162638.2
(22) Date de dépôt: 12.06.2009
(51) Int. Cl.: B81C 99/00, C25D 1/00

(54) **Procédé de fabrication d'une microstructure métallique et microstructure obtenue selon ce procédé**

(71) Demandeur: Nivarox-FAR S.A., CH-2400 Le Locle (CH)
(72) Inventeur: Fussinger, Alexandre, 2075, Wavre (CH)
(74) Mandataire: Ravenel, Thierry Gérard Louis

(57) **Abrégé**

La présente invention concerne un procédé de fabrication d'une pluralité de microstructures métalliques **caractérisé en ce qu**'il comprend les étapes consistant à
a) se munir d'un substrat conducteur ou d'un substrat isolant recouvert d'une couche conductrice d'amorçage.
b) appliquer sur la partie conductrice de la surface du substrat une couche de résine photosensible,
c) aplanir la surface de la couche de résine photosensible jusqu'à une épaisseur et/ou un état de surface désiré
d) irradier la couche de résine à travers un masque définissant le contour de la microstructure désirée ;
e) dissoudre les zones non polymérisées de la couche de résine photosensible pour faire apparaître par endroit la surface conductrice du substrat,
f) déposer électro-galvaniquement au moins une couche d'un métal à partir de ladite couche conductrice pour former un bloc atteignant sensiblement la surface supérieure de la résine photosensible.
g) aplanir la résine et le métal électro formé pour amener la résine et les blocs électro formés au même niveau et ainsi former des pièces ou microstructure électro formées,
h) séparer la couche de résine et le bloc électro-déposé du substrat et
i) éliminer la couche de résine photosensible de la structure obtenue à l'issu de l'étape g) pour libérer les microstructures ainsi formées.

## Description

La présente invention concerne un procédé de fabrication d'une microstructure métallique par une technologie de type LIGA. En particulier l'invention concerne un tel procédé pour la fabrication d'une telle microstructure ayant des caractéristiques dimensionnelles plus précises et mieux contrôlées que les procédés de l'art antérieur. L'invention concerne également un telle pièce métallique obtenue par ce procédé.

La technologie LIGA (Lithographie Galvanik Abformung) développée par W. Ehrfeld du Karlsruhe Nuclear Research Center, Allemagne) dans les années 80 s'est révélée intéressante pour la fabrication de microstructures métalliques de hautes précisions.

Dans son principe la technique LIGA consiste à déposer sur un substrat conducteur ou revêtu d'une couche conductrice, une couche d'une résine photosensible, à effectuer à travers un masque correspondant au contour de la microstructure désirée une irradiation X au moyen d'un synchrotron; à développer, c'est-à-dire à éliminer par des moyens physiques ou chimiques les portions de la couche de résine photosensible non irradiées afin de définir un moule ayant le contour de la microstructure, à déposer électro-galvaniquement un métal typiquement du nickel dans le moule en résine photosensible puis à éliminer le moule pour libérer la microstructure.

La qualité des microstructures obtenues ne prête pas à critique, mais la nécessité de mettre en oeuvre un équipement coûteux (synchrotron) rend cette technique peu compatible avec une production de masse de microstructures devant avoir un faible coût unitaire.

C'est pourquoi sur la base de ce procédé LIGA ont été développées des procédé analogues mais utilisant des résines photosensibles aux UV. Un tel procédé est par exemple décrit dans la publication de A.B. Frazier et al., intitulée « Metallic Microstructures Fabricated Using Photosensitive Polyimide Electroplating Molds", Journal of Microelectromechanical systems, Vol, 2, N deg. 2, June 1993 pour la fabrication de structures métalliques par électrodéposition de métal dans des moules en résine photosensible à base de polyimide. Ce procédé comprend les étapes suivantes :
- créer sur substrat une couche métallique sacrificielle et une couche d'amorçage pour une étape ultérieure d'électrodéposition,
- appliquer une couche de résine polyimide photosensible,
- irradier à l'UV la couche de résine polyimide à travers un masque correspondant au contour de la microstructure désirée,
- développer en dissolvant les parties non irradiées de la couche de polyimide de façon à obtenir une pluralité de moules en polyimide,
- déposer électro-galvaniquement du nickel dans les parties ouvertes des moules jusqu'à la hauteur de ces derniers, et
- séparer les structures métalliques obtenues du substrat et
- éliminer les moules en polyimide pour libérer les pièces métalliques électroformées.

Les pièces ou microstructures électro formées sont donc obtenues en vrac. Une fois obtenues, ces pièces sont donc séparées et doivent être recollées sur une plaque afin de les usiner et/ou rectifier pour les amener à l'épaisseur et à l'état de surface désirés. Ces étapes requièrent des temps de manipulation élevés et comportent des risques important de disposer les pièces à l'envers sur ladite plaque notamment lorsque les pièces électroformées sont de faibles dimensions, typiquement des pièces de dimensions inférieures au millimètre. Ces procédés induisent un taux de rebut et donc des coûts de revient non compatibles avec les exigences d'un procédé industriel.

Par ailleurs les procédés de l'art antérieur nécessitent un dépôt de matière électro-formée suffisamment important pour garantir que toutes les pièces atteignent leur épaisseur minimum indépendamment des variations d'épaisseur de la résine à la surface du substrat. Ceci entraine donc une consommation de matière électro-déposée inutile.

En effet, les variations d'épaisseurs de la résine déposée pour former les moules sont intrinsèques aux techniques de dépôts actuel, typiquement la tournette ou le spray coating. On notera à ce propos que la non uniformité de la couche de résine dans laquelle les moules sont formés nécessite d'irradier la résine avec un réglage prenant en compte le maximum et le minimum de l'épaisseur. Cela a pour conséquence d'augmenter la dispersion des dimensions géométriques dans le plan des moules.

Il existe donc un besoin pour un procédé permettant de s'affranchir de ces inconvénients.

La présente invention a pour but de remédier aux inconvénients susmentionnés ainsi qu'à d'autres encore en fournissant un procédé permettant de fabriquer des pièces ou microstructures ayant des épaisseurs et des états de surfaces mieux contrôlés et plus précis que les pièces ou microstructures obtenues par les procédés de l'art antérieur.

L'invention a également pour but un tel procédé permettant une réduction des coûts de l'électroformage tant du point de vue du temps de fabrication que de la quantité de matière électro déposée.

L'invention a également pour but d'améliorer l'uniformité de l'exposition photolithographique et donc l'amélioration de l'uniformité géométrique des pièces produites sur la surface d'un même substrat.

La présente invention a également pour but de fournir un tel procédé qui soit simple et peu coûteux à mettre en oeuvre.

A cet effet l'invention a pour objet un procédé de fabrication d'une pluralité de pièces ou microstructures métalliques **caractérisé en ce qu**'il comprend les étapes consistant à :
a) se munir d'un substrat conducteur ou d'un substrat isolant recouvert d'une couche conductrice d'amorçage.
b) appliquer sur la partie conductrice de la surface du substrat une couche de résine photosensible,
c) aplanir la surface de la couche de résine photosensible jusqu'à une épaisseur et/ou un état de surface désiré ;
d) irradier la couche de résine à travers un masque définissant le contour de la microstructure désirée ;
e) dissoudre les zones non polymérisées de la couche de résine photosensible pour faire apparaître par endroit la surface conductrice du substrat ou le substrat si ce dernier est conducteur.
f) déposer électro-galvaniquement au moins une couche d'un métal à partir de ladite couche conductrice pour former des blocs atteignant sensiblement la surface supérieure de la résine photosensible,
g) aplanir la résine et le métal électro formé pour amener la résine et les blocs électro formés au même niveau et ainsi former des pièces ou microstructures électro formées,
h) séparer la couche de résine et les pièces électro-formées du substrat, et
i) éliminer la couche de résine photosensible des pièces ou microstructures obtenues à l'issu de l'étape h) pour libérer les pièces ou microstructures ainsi formées.

Ce procédé permet donc de réaliser une couche de résine d'une épaisseur déterminée et constante sur toute la surface du substrat. Cela permet donc d'exposer une couche de résine présentant une épaisseur uniforme ce qui permet la réalisation de moules puis de pièces terminées présentant une précision dimensionnelles uniforme dans le plan pour les pièces d'un même substrat. Typiquement le procédé de l'invention permet de garantir une précision de +/- 2 µm sur l'épaisseur de la résine déposée, alors que les procédés de l'art antérieur sont limités à une précision de l'ordre +/- 30 µm (dépôt à la tournette).

Par ailleurs l'aplanissement de la résine avant l'étape d'électroformage des pièces permet, d'une part, de limiter la quantité de métal à déposer pour obtenir plus tôt des ponts entre les pièces comme cela sera expliqué ci-après (gain de temps) et, d'autre part, d'obtenir une galette c'est-à-dire un ensemble de pièces électro formées reliées entre elles pour des ponts de matière beaucoup plus régulière en épaisseur du côté supérieur pour garantir un collage plus régulier sur la plaque de travail pour des opérations d'usinage ultérieurs.

Dans le cas d'un procédé LIGA multiniveaux, l'aplanissement de la résine permet d'obtenir une tolérance serrée sur l'épaisseur des différents niveaux sur toute l'étendue du substrat, donc sur toutes les pièces du substrat.

Selon une caractéristique de l'invention, l'étape d'aplanissement c) est réalisée à l'aide d'un outil de coupe et de préférence à l'aide d'un outil comportant une portion coupante en métal dur, en céramique, en carbure métallique, en nitrure métallique ou en diamant.

L'utilisation d'un tel outil pour réaliser l'étape d'aplanissement permet d'éviter toute contamination de la résine et/ou du métal électroformé par des résidus qui résulterait des procédés de meulage ou de polissage. De plus, l'usinage à raide d'un outil de coupe n'est pas sensible aux différences d'épaisseur de la matière à usiner (résine ou résine et pièces électroformées ou pièces collées sur une plaque de travail).

Selon une première variante avantageuse de l'invention, durant l'étape f) le métal est déposé au-delà de la hauteur du moule pour s'étendre sur la surface aplanie de la résine et ainsi relier les pièces entre elles par des ponts métalliques pour former une galette, l'étape g) est éliminée et après l'étape h), les pièces métalliques reliées entre elles par lesdits ponts sont soumises aux étapes suivantes de:
j) fixation sur une plaque de travail par leur face de référence opposée aux ponts,
k) usinage de leurs faces exposées pour les mettre à l'épaisseur et/ou à l'état de surface désiré tout en éliminant les ponts, libérant ainsi lesdites pièces les unes des autres
l) libération desdites pièces terminées de la plaque de travail.

Selon cette première variante de réalisation, les ponts métalliques entre les pièces permettent :
1. le transfert des pièces sur la plaque de travail pour la mise en épaisseur
2. de garantir un pressage régulier sur la plaque de travail au moment de la fixation des pièces sur celle-ci ce qui permet de réduire la dispersion de la cote d'épaisseur finie.
3. de garantir l'arrangement précis et régulier des pièces pour une opération subséquente d'usinage additionnel (électroérosion, usinage par enlèvement de copeaux, diamantage, polissage, décors, etc.)

Autrement dit, on réalise une surcroissance de métal lors de la déposition LIGA pour créer des ponts entre toutes les pièces et pouvoir ainsi manipuler la galette qui conserve la localisation très régulière et précise des pièces obtenues par le procédé LIGA. Cette galette peut être ensuite solidarisée à une plaque de travail. La reprise mécanique des pièces peut ainsi se faire sur une machine CNC en bénéficiant du positionnement précis des pièces (des repères peuvent être électro formés directement sur la galette).

Le procédé de invention permettant avantageusement de conserver l'arrangement précis et régulier des pièces après enlèvement des ponts de matière é!ectroformée pour réaliser des pièces multiniveaux par usinage, réaliser des décors, réaliser des revêtements (sélectifs ou complets), réaliser des chanfreins ou lamages, assemblage en batch, etc. au moyen de machines à commande numérique, de robots, pour une production industrielle.

Selon une deuxième variante de réalisation, l'étape g) est éliminée et après l'étape de séparation h) les pièces électro-formées ne sont plus reliées entre elles, ces pièces sont soumises aux étapes suivantes de ,
m) application d'une bande de transfert sur la face opposée à la face de référence desdites pièces;
n) fixation sur une plaque de travail par leur face de référence opposée à la bande,
o) usinage de leurs faces exposées pour les mettre à l'épaisseur et/ou à l'état de surface désiré
p) libérer lesdites pièces terminées de la plaque de travail.

Selon une troisième variante de réalisation, dans lequel après l'étape de séparation h) les pièces électro-formées ne sont pas reliées entre elles par des ponts métalliques, mais par la résine. Ces pièces sont soumises aux étapes suivantes de :
q) fixation sur une plaque de travail par leur face de référence,
r) usinage de leurs faces exposées pour les mettre à l'épaisseur et/ou à l'état de surface désiré,
s) libération desdites pièces terminées de la plaque de travail,

Selon une caractéristique avantageuse de l'invention, avant l'étape k) les pièces encore fixées sur la plaque de travail sont soumises à une étape d'usinage dans l'épaisseur des pièces.

Les étapes k) o) r) décrites ci-dessus peuvent bien entendu être réalisée par des outils de coupe.

Le procédé de l'invention trouve une application particulièrement avantageuse pour la fabrication de pièces micromécaniques de mouvements d'horlogerie ou d'outillage. En particulier les pièces pourront être choisies parmi l'ensemble constitué des roues dentées, des roues d'échappement, des ancres, des pièces pivotées, des ressorts sautoir, des ressorts spiral et des pièces passives, des cames, des poussoirs, des viroles, de moules, de broches, de tasseaux, d'électrodes pour l'éléctro-érosion.

D'autres caractéristiques et avantages de la présente invention ressortiront plus clairement de la description détaillée qui suit d'un exemple de réalisation d'un procédé selon l'invention, cet exemple étant donné à titre purement illustratif et non limitatif seulement, en liaison avec le dessin annexé sur lequel:
- les figures 1a à 1h illustrent les étapes de procédé d'un premier mode de réalisation de l'invention en vue de la réalisation d'une pluralité de roues dentées.
- les figures 2a à 2k illustrent une première variante de réalisation de invention.
- les figures 3a à 3k illustrent une deuxième variante de réalisation de l'invention.
- les figures 4a à 4j illustrent une troisième variante de réalisation de l'invention

En se référant aux figures la à 1 h on va décrire un premier mode de réalisation de l'invention,

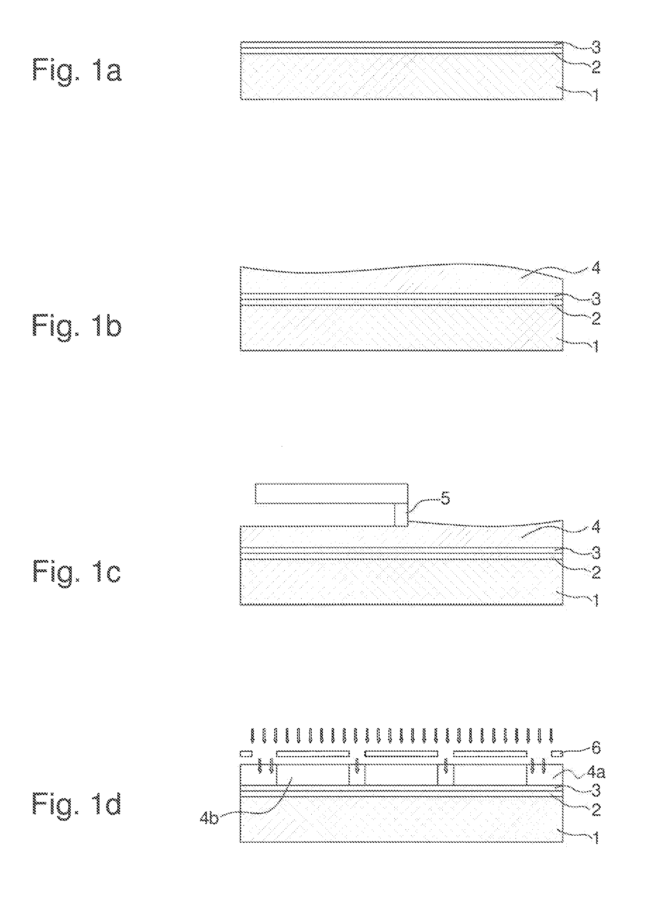

Le substrat 1 utilisé dans l'étape a) du procédé selon l'invention est par exemple formé par une plaquette de silicium, de verre ou de céramique sur laquelle on a déposé par évaporation, une couche d'amorçage, c'est-à-dire une couche apte à démarrer une réaction d'électroformage. Typiquement la couche d'amorçage est formée d'une sous couche de chrome 2 et d'une couche d'or 3 (figure 1a).

Alternativement, le substrat peut être réalisé en acier inoxydable ou en un autre métal apte à démarrer une réaction d'électroformage. Dans ce cas, la couche d'amorçage 2, 3 n'est plus nécessaire. Dans le cas d'un substrat en acier inoxydable, ce dernier sera dégraissé avant usage.

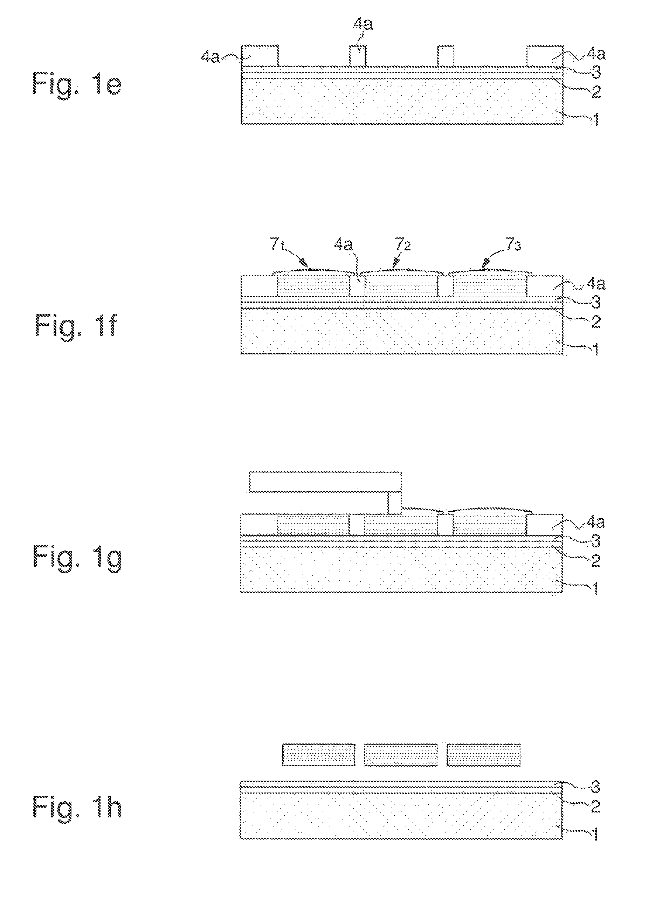

La résine photosensible 4 utilisée à l'étape b) du procédé selon invention est de préférence une résine à base d'époxy octofonctionnelle disponible chez Shell Chemical sous la référence SU-8 et d'un photoinitiateur choisi parmi les sels de triarylslilfonium tels que ceux décrits dans le brevet US 4,058,401. Cette résine est susceptible d'être polymérisée sous l'action d'un rayonnement UV. On notera qu'un solvant qui s'est révélé approprié pour cette résine est la gammabutyrolactone (GBL) (figure 1 b).

Alternativement, une résine à base de phénolformaldéhydique de type 2Novolac en présence d'un photoinitiateur DNQ (DiazoNaphtoQuinone) peut également être utilisée.

La résine 4 est déposée sur le substrat 1 par tout moyen approprié typiquement à la tournette jusqu'à l'épaisseur souhaitée. Typiquement l'épaisseur de résine est comprise entre 150 µm et 1mm. Selon l'épaisseur désirée et la technique de dépôt utilisée, la résine 4 sera déposée en une ou plusieurs fois. Alternativement, la résine 4 peut être déposée par la technique de spray coating.

La résine 4 est ensuite chauffée entre 80 et 95° C pendant une durée dépendant de l'épaisseur déposée pour évacuer le solvant Ce chauffage sèche et durcit la résine.

A l'étape c), le substrat est monté sur le porte pièce d'une machine outil sur laquelle on procède à l'aplanissement de la surface de la couche de résine photosensible durcie jusqu'à une épaisseur et/ou un état de surface désiré (figure 1c). Cette opération d'aplanissement est réalisée au moyen d'un outil de coupe 5 de manière à éviter toute contamination de la résine par des résidus que pourrait provoquer un aplanissement par un outil d'abrasion classique. On notera que cette opération d'aplanissement est réalisée de préférence à sec, c'est-à-dire sans aucune lubrification afin d'éviter toute pollution chimique de la résine. Typiquement, l'outil de coupe est un outil comportant une portion coupante en métal dur, en céramique, en carbure métallique, en nitrure métallique ou en diamant. A l'issue de cette étape, on obtient un substrat revêtu d'une couche de résine 4 dont la surface est parfaitement plane et parallèle au substrat. La résine présente en outre un état de surface ayant une valeur de Ra < 25 nm et une épaisseur désirée avec une tolérance de ± 2µm.

L'état de surface obtenu ainsi que la précision géométrique de l'épaisseur de la résine sont particulièrement intéressants dans le cas d'un procédé multiniveaux car cet état de surface détermine l'état de surface du dépôt galvanique crû à partir de cette surface et l'épaisseur maîtrisée permet de garantir les cotes de chaque niveau de chaque pièce.

L'étape d) suivante illustrée à la figure 1d consiste à irradier la couche de résine aplanie au moyen d'un rayonnement UV à travers un masque 6 définissant le contour des microstructures désirées et ainsi des zones insolées 4a et des zones non insolées 4b. Typiquement cette irradiation UV est de 200 à 1'000 mJ.cm⁻², mesurée à une longueur d'onde de 365 nm selon l'épaisseur de la couche. Le cas échéant une étape de recuit de la couche peut être nécessaire pour compléter la photopolymérisation induite par l'irradiation UV. Cette étape de recuit est effectuée de préférence entre 90°C et 95°C pendant 15 à 30 mn. Les zones insolées (photopolymérisées) deviennent insensibles à une grande majorité de solvants. Par contre, les zones non insolées pourront ultérieurement être dissoutes par un solvant.

L'étape e) suivante illustrée à la figure 1e consiste à développer les zones non insolées 4b de la couche de résine photosensible pour faire apparaître par endroit la couche conductrice 3 du substrat 1. Cette opération est réalisée par dissolution des zones non insolées 4b au moyen d'un solvant choisi parmi la GBL (gammabutyrolactone) et le PGMEA (propylène glycol méthyle éthyle acétate). Une pluralité de moules en résine photosensible insolée 4a présentant les contours des structures métalliques sont ainsi réalisés.

L'étape f) suivante illustrée à la figure 1f consiste à déposer électro-galvaniquement dans les moules une couche d'un métal à partir de ladite couche conductrice 3 jusqu'à former une pluralité de blocs 7₁, 7₂, 7₃ atteignant et dépassant la hauteur des moules. Par métal dans ce contexte sont bien entendu compris les alliages métalliques. Typiquement le métal sera choisi parmi l'ensemble comprenant le nickel, le cuivre, l'or ou l'argent, et comme alliage l'or-cuivre, le nickel-cobalt, le nîckel-fer, et le nickel-phosphore, nickel tungstène.

Les conditions d'électroformage, notamment la composition des bains, la géométrie du système, les tensions et densités de courant, sont choisis pour chaque métal ou alliage à électro-déposer selon les techniques bien connues dans l'art de l'électroformage (cf. par exemple Di Bari G.A. "electroforming" Electroplating Engineering Handbook 4th Edition rédigée par L.J. Durney, publie par Van Nostrand Reinhold Compagny Inc., N.Y. USA 1984).

Dans une étape g) subséquente illustrée à la figure 1g on procède à la mise à niveau du bloc électro-formé avec la couche de résine. Cette étape peut se faire par abrasion et polissage ou usinage par un outil de coupe afin d'obtenir directement des microstructures ayant une surface supérieure plante présentant notamment un état de surface compatible avec les exigences de l'industrie horlogère pour la réalisation de mouvement de haut de gamme.

L'étape h) suivante illustrée à la figure 1h consiste à séparer la couche de résine 4a et le bloc électro-déposé 7₁, 7₂, 7₃ du substrat 1. Une fois cette opération de délamination effectuée, on élimine la couche de résine photosensible 4a de la structure délaminée pour libérer les microstructures 7₁, 7₂, 7₃ ainsi formées. Pour ce faire, on élimine dans une étape finale la résine par une attaque plasma.

La microstructure ainsi libérée peut être utilisée soit directement soit, le cas échéant, après un usinage approprié.

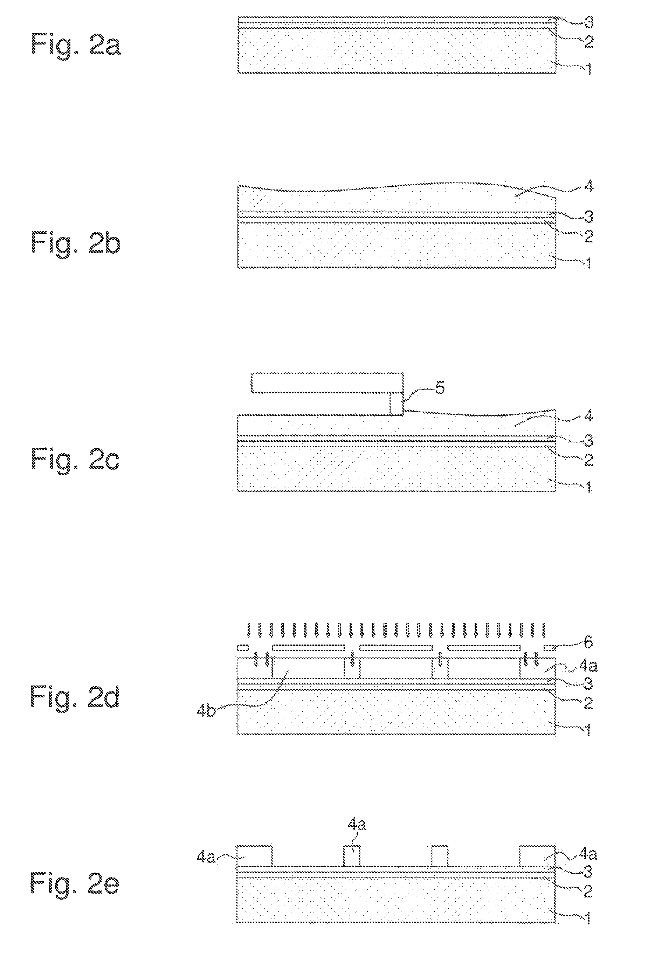

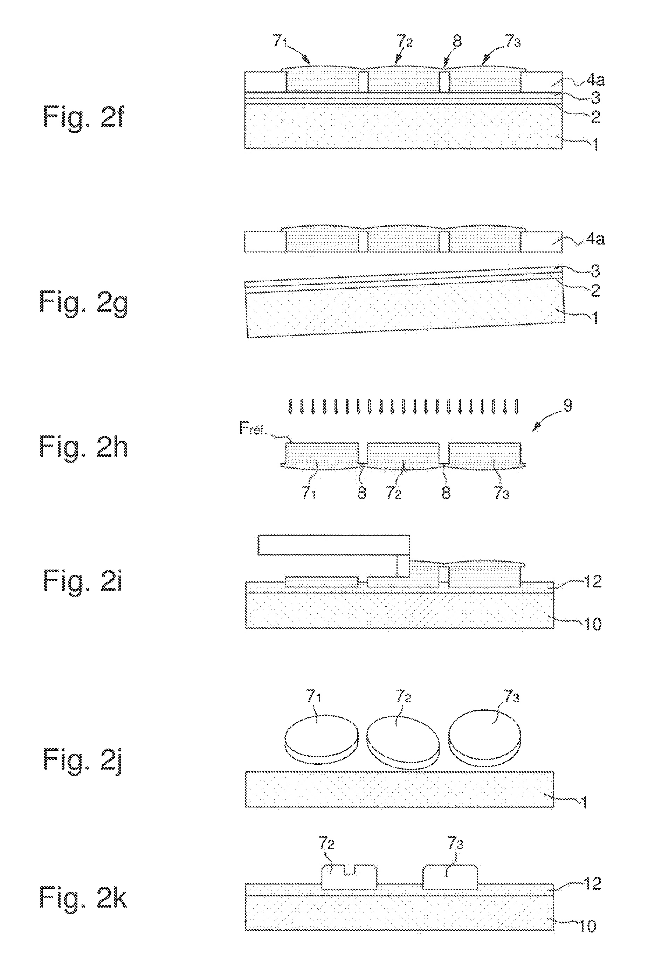

On va maintenant décrire une première variante de l'invention en liaison avec les figures 2a à 2k. Dans cette première variante, les étapes illustrée aux figures 2a à 2e sont identiques à celles décrites et illustrées aux figures 1a à 1e. Dans cette première variante, au cours de l'étape f) le dépôt électro-galvanique dans les moules est réalisé jusqu'à former une pluralité de blocs 7₁, 7₂, 7₃ atteignant et dépassant la hauteur des moules de manière à s'étendre sur la surface supérieure de la résine photosensible 4a et former des ponts métalliques 8 pour relier les différents blocs 7₁, 7₂, et 7₃ entre eux (figure 2f), L'étape g) est éliminée. On sépare ensuite le substrat 1 de l'ensemble résine 4a et blocs 7₁, 7₂, 7₃ électroformés au cours d'une étape de délaminatage (figure 2g). La résine 4a est alors éliminée pour libérer les blocs 7₁, 7₂, 7₃ reliés entre eux par les ponts 8 formant une galette 9. Typiquement l'élimination de la résine 4a est réalisée par une attaque plasma (figure 2h). La galette 9 est ensuite fixée typiquement par collage (colle 12) sur une plaque de travail 10 par sa face de référence F_{réf.} opposée aux ponts, c'est-à-dire la face qui était en contact avec le substrat 1 (figure 2i). Les faces exposées sont usinées pour mettre les blocs 7₁, 7₂, et 7₃ à l'épaisseur et/ou à l'état de surface désiré tout en éliminant les ponts 8 et former des pièces finies ou semi finies. Au cours de cette étape, lesdits blocs 7₁, 7₂, et 7₃ sont libérés les uns des autres tout en étant encore maintenus en position précise et définie dans la colle 12 (figure 2i). A l'issue de cette étape, lesdites pièces obtenues peuvent être soit libérées de la plaque de travail 10 puis nettoyées (figure 2j), soit reprises sur une machine outil pour opérer des usinages en lot (figure 2k). A ce stade, les pièces peuvent être soumises à divers traitements décoratifs et/ou fonctionnels, typiquement des dépôts physiques ou chimiques.

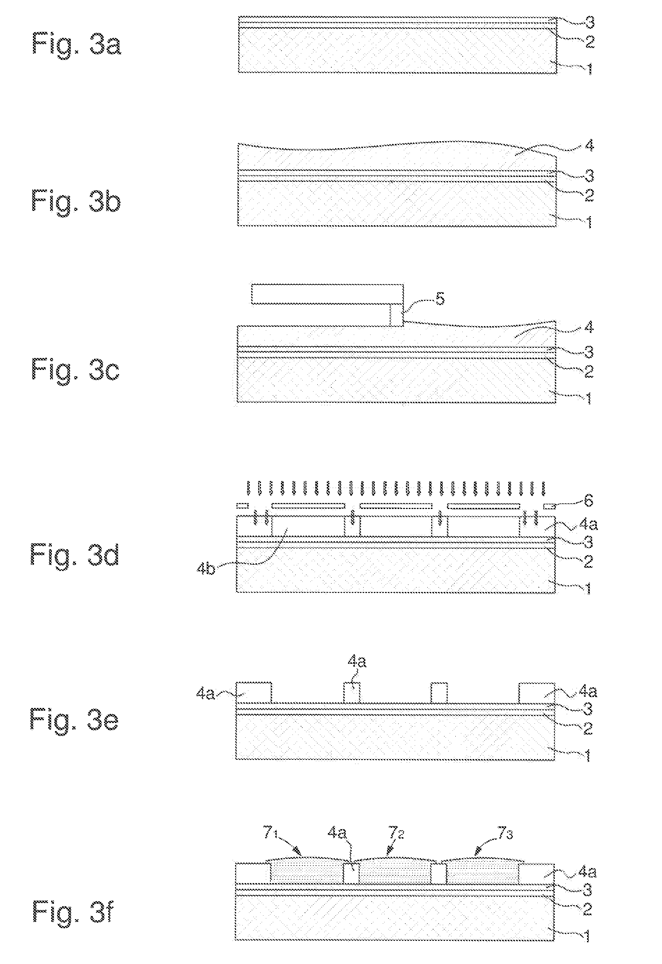

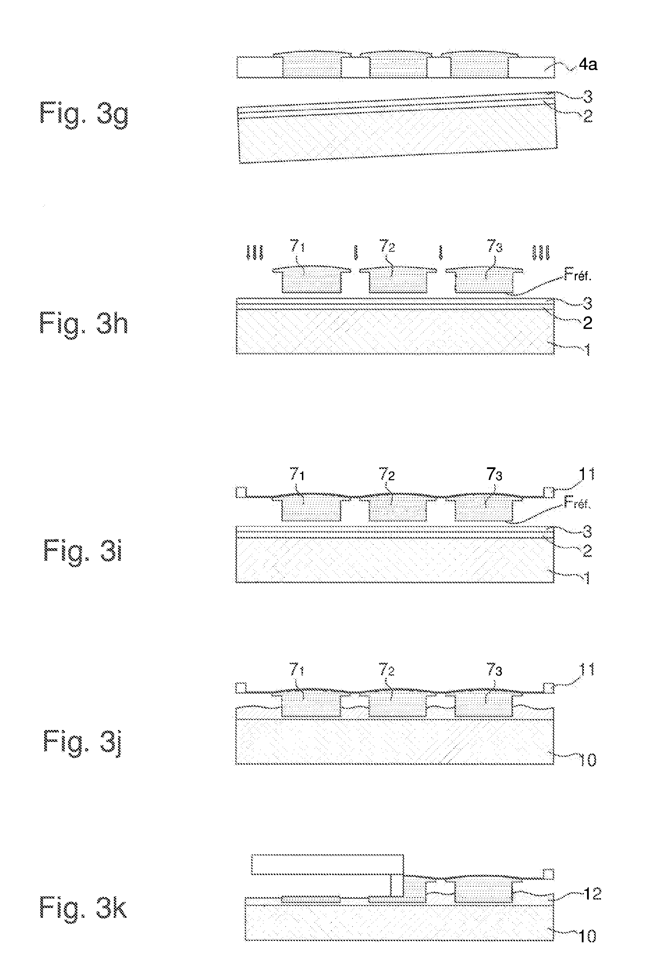

On va maintenant décrire une deuxième variante de l'invention en liaison avec les figures 3a à 3k. Dans cette deuxième variante, les étapes illustrée aux figures 3a à 3f sont identiques à celles décrites et illustrées aux figures 1a à 1f. Dans cette deuxième variante l'étape g) est également éliminée et après l'étape f), on sépare le substrat 1 de l'ensemble résine 4a et blocs électroformés 7₁, 7₂ et 7₃ au cours d'une étape de délamination (figure 3g). La résine 4a est alors éliminée pour libérer les blocs 7₁, 7₂ et 7₃. Typiquement l'élimination de la résine est réalisée par une attaque plasma (figure 3h). Les blocs électroformées 7₁, 7₂, 7₃ ne sont plus reliés entre eux. On applique ensuite une bande de transfert tendue sur un cadre 11 sur la face opposée à la face de référence F_{ref.} desdits blocs c'est-à-dire la face qui était en contact avec le substrat 1 (figure 3i). Les blocs 7₁, 7₂, 7₃ collées sur la bande de transfert sont ensuite fixés typiquement par collage sur une plaque de travail 10 par leur face de référence, c'est-à-dire la face qui était en contact avec le substrat 1 (figure 3j). Le cadre est retiré en laissant la bande de transfert. Les faces exposées des blocs sont ensuite usinées pour former les pièces 7₁, 7₂ et 7₃ à l'épaisseur et/ou à l'état de surface désiré tout en éliminant la bande transfert. Au cours de cette étape, lesdits pièces sont libérées les unes des autres de la bande de transfert tout en étant maintenues dans la colle 12 (figure 3k). A l'issue de cette étape, lesdites pièces sont libérées de la plaque de travail 10 puis nettoyées.

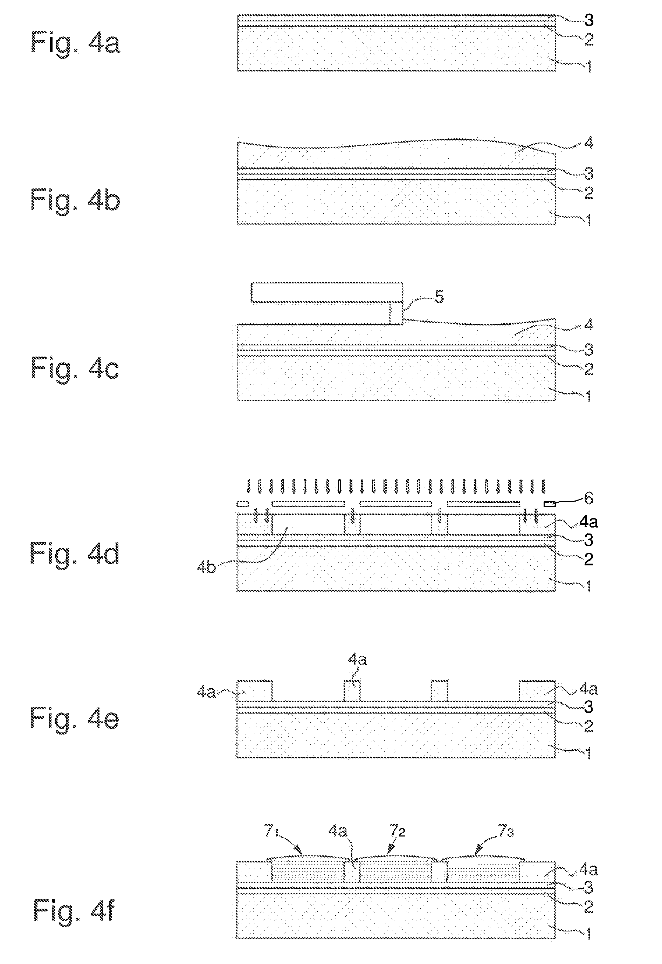

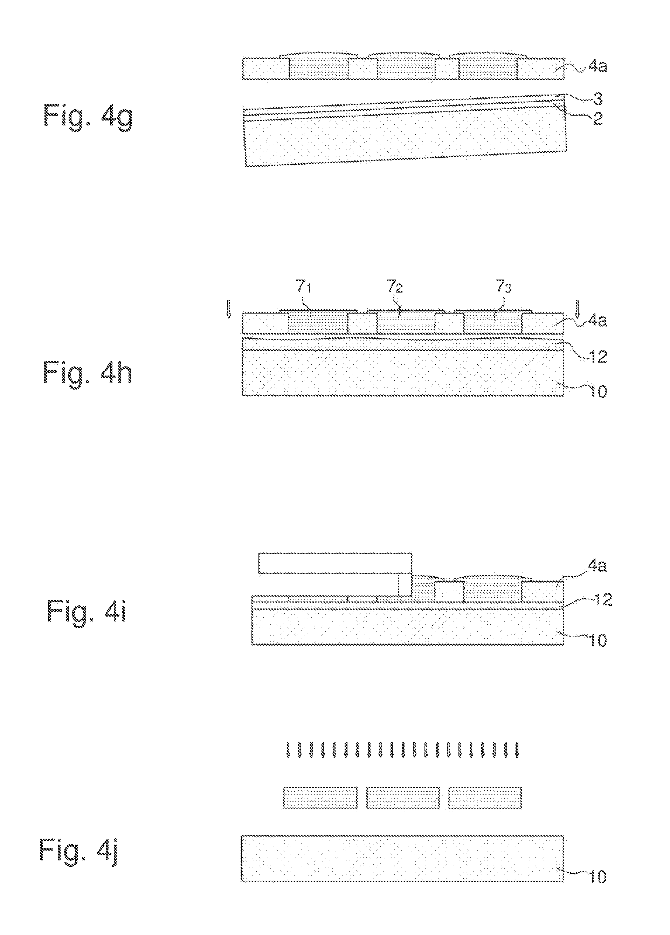

On va maintenant décrire une troisième variante de l'invention en liaison avec les figures 4a à 4j. Dans cette troisième variante, les étapes illustrée aux figures 4a à 4f sont identiques à celles décrites et illustrées aux figures 1a à 1f. Dans cette troisième variante, l'étape g) est également éliminée. Cette variante s'applique dans le cas où l'adhérence de l'ensemble résine-blocs électroformés n'est pas suffisante pour permettre un usinage direct des blocs 7₁, 7₂, 7₃ sur le substrat 1. Dans ce cas, on sépare le substrat 1 de l'ensemble résine 4a et blocs électro formés 7₁, 7₂ et 7₃ au cours d'une étape de délamination (figure 4g). On procède ensuite au collage de l'ensemble résine-blocs électroformés sur une plaque de travail 10 par leur face de référence, c'est-à-dire la face qui était en contact avec le substrat 1 (figure 4h). Les faces exposées des blocs 7₁, 7₂, 7₃ sont ensuite usinées pour former les pièces à l'épaisseur et/ou à l'état de surface désiré. Les pièces sont maintenues par la résine 4a et par la colle 12 (figure 4i). A l'issue de cette étape, lesdites pièces sont libérées de la plaque de travail 1 puis la résine 4a est alors éliminée pour libérer les pièces obtenues. Typiquement l'élimination de la résine est réalisée par une attaque plasma (figure 4j). Selon l'invention, on notera encore qu'avant l'étape illustrée respectivement aux figures 1e, 2e, 3e, et 4e les étapes illustrées et décrites en liaison respectivement avec les figures 1b à 1d, 2b à 2d, 3b à 3d et 4b à 4d sont répétées au moins une fois pour obtenir des pièces multiniveaux.

Le nombre de niveaux n'est donc pas limité. Pour des applications horlogère le nombre typique de niveaux est de 1 à 5.

Dans le cas de la réalisation de moules en résine multiniveaux, il est avantageux de déposer sur la résine après l'étape 1d, 2d, 3d, 4d une couche conductrice permettant une croissance régulière de la matière électro déposée au cours de l'étape ultérieure 1f, 2f ,3f ,4f,

## Revendications

1. procédé de fabrication d'une pluralité de microstructures métalliques **caractérisé en ce qu'**il comprend les étapes consistant à :
a) se munir d'un substrat conducteur ou d'un substrat isolant recouvert d'une couche conductrice d'amorçage.
b) appliquer sur la partie conductrice de la surface du substrat une couche de résine photosensible,
c) aplanir la surface de la couche de résine photosensible jusqu'à une épaisseur et/ou un état de surface désiré
d) irradier la couche de résine à travers un masque définissant le contour de la microstructure désirée ;
e) dissoudre les zones non polymérisées de la couche de résine photosensible pour faire apparaître par endroit la surface conductrice du substrat,
f) déposer électro-galvanlquement au moins une couche d'un métal à partir de ladite couche conductrice pour former un bloc atteignant sensiblement la surface supérieure de la résine photosensible,
g) aplanir la résine et le métal électro formé pour amener la résine et les blocs électro formés au même niveau et ainsi former des pièces ou microstructure électro formées,
h) séparer la couche de résine et le bloc électro-déposé du substrat, et
i) éliminer la couche de résine photosensible de la structure obtenue à l'issu de l'étape g) pour libérer les microstructures ainsi formées.

2. Procédé selon la revendication 1 **caractérisé en ce que** l'étape d'aplanissement c) est réalisée à l'aide d'un outil de coupe.

3. Procédé selon la revendication 2 **caractérisé en ce que** l'outil de coupe est un outil comportant une portion coupante en métal dur, céramique, carbure métallique, nitrure métallique ou en diamant.

4. Procédé selon l'une des revendications 1 à 3, **caractérisé en ce** durant l'étape f) le métal est déposé au-delà de la hauteur du moule pour s'étendre sur la surface aplanie de la résine de manière à relier les pièces entre elles par des ponts métalliques.

5. Procédé selon la revendications 4 **caractérisé en ce qu'**après l'étape h), les pièces métalliques reliées entre elles par lesdits ponts sont soumises aux étapes suivantes de:
j) fixation sur une plaque de travail par leur face de référence opposée aux ponts,
k) usinage de leurs faces exposées pour les mettre à l'épaisseur et/ou à l'état de surface désiré tout en éliminant les ponts, libérant ainsi lesdites pièces les unes des autres
l)libération desdites pièces terminées de la plaque de travail.

6. Procédé selon l'une des revendications 1 à 3 **caractérisé en ce qu'**après l'étape de séparation g) les pièces électro-formées ne sont plus reliées entre elles et sont soumises aux étapes suivantes de:
m) application d'une bande de transfert sur la face opposée à la face de référence desdites pièces ;
n) fixation sur une plaque de travail par leur face de référence opposée à la bande de transfert,
o) usinage de leurs faces exposées pour les mettre à l'épaisseur et/ou à l'état de surface désiré
p) libération desdites pièces terminées de la plaque de travail.

7. Procédé selon l'une des revendications 1 à 3 **caractérisé en ce qu'**après l'étape de séparation g) les pièces métalliques reliées entre elles par la résine sont soumise aux étapes suivantes de :
q) fixation sur une plaque de travail par leur face de référence,
r) usinage de leurs faces exposées pour les mettre à l'épaisseur et/ou à l'état de surface désiré,
s) libération desdites pièces terminées de la plaque de travail et de la résine.

8. Procédé selon l'une des revendications 5 à 7, **caractérisé en ce qu'**avant l'étape k) les pièces encore fixées sur la plaque de travail sont soumises à une étape d'usinage dans l'épaisseur des pièces.

9. Procédé selon la revendication 1, **caractérisé en ce qu'**avant l'étape e) les étapes b) c) et d) sont répétée au moins une fois pour obtenir des pièces multi niveaux.

10. Microstructure métallique obtenue selon l'une des revendications précédentes, **caractérisée en ce qu'**elle forme une pièce micromécanique d'un mouvement d'horlogerie ou d'outillage et étant notamment choisie parmi l'ensemble constitué des roues dentées, des roues d'échappement, des ancres, des pièces pivotées, des ressorts sautoir, des ressorts spiral et des pièces passives, des cames, des poussoirs, de moules, de broches, de tasseaux, d'électrodes pour l'électroérosion.
